# FASCICULE DE BREVET EUROPEEN

(11) **EP 1 357 386 B1**
(45) Date de publication et mention de la délivrance du brevet: **30.05.2018**
(21) Numéro de dépôt: 03354037.8
(22) Date de dépôt: 18.04.2003
(51) Int. Cl.: G01R 27/26, G01R 27/16, G01R 27/18

(54) **Dispositif et procédé de détection de charge électrique, et appareil électrique comportant un tel dispositif**
Vorrichtung und Verfahren zur Detektion von elektrischen Ladungen und elektrisches Gerät mit einer solchen Anordnung
Device and method for electrical charge detection and electrical apparatus equipped with such a device

(30) Priorité: 19.04.2002 FR 0204910
(43) Date de publication de la demande: 29.10.2003
(73) Titulaire: Schneider Electric Industries SAS, 92500 Rueil-Malmaison (FR)
(72) Inventeur: Clausse, Christine, Schneider Electric Ind. SAS, 38050 Grenoble cedex 09 (FR); Landes, Olivier, Schneider Electric Industries SAS, 38050 Grenoble cedex 09 (FR); Leprettre, Benoit, Schneider Electric Industr. SAS, 38050 Grenoble cedex 09 (FR); Perichon, Pierre, Schneider Electric Industr. SAS, 38050 Grenoble cedex 09 (FR)
(74) Mandataire: Tripodi, Paul

(56) Documents cités:
- US-A- 6 038 115

## Description

### DOMAINE TECHNIQUE

L'invention concerne un dispositif de détection de charge électrique comportant des moyens de contrôle destinés à être connectés à au moins un conducteur d'une ligne électrique et des moyens de signalisation connectés audits moyens de contrôle, les moyens de contrôle comportant :
- des moyens d'injection pour injecter une tension électrique de mesure sur la ligne électrique lorsque ladite ligne est déconnectée d'un réseau fournissant une énergie électrique,
- des moyens de détection d'impédance pour détecter l'impédance d'une charge électrique, et
- des moyens de traitement pour déterminer si ladite charge est représentative de la présence d'un corps humain.

L'invention concerne aussi un appareil électrique comportant une entrée destinée à être connectée à un réseau électrique, une sortie destinée à être connectée à une ligne électrique d'alimentation, et des moyens d'interruption électrique connectés entre ladite entrée et ladite sortie.

L'invention concerne aussi un procédé de détection de charge électrique dans au moins un conducteur d'une ligne électrique comportant une phase de contrôle lorsque la ligne n'est pas alimentée par un réseau électrique.

### ETAT DE LA TECHNIQUE

Les dispositifs de détection connus comportent des circuits pour injecter une tension dans une ligne d'un réseau électrique et mesurer l'impédance de la ligne. Une détection de présence de corps humain est déduite si l'impédance de ligne est supérieure à une valeur prédéfinie. Certains dispositifs comportent aussi un test de détection de composantes inductives dans la charge pour améliorer le contrôle. Des dispositifs de ce type sont décrits dans les demandes de brevets WO86/02500 et WO89/1174. D'autres dispositifs injectent des types de tension différents, par exemple une tension continue et une tension alternative de fréquence élevée en très basse tension de l'ordre de 5 Volts comme dans le document US6038115.

Ces dispositifs connus ont un faible taux de reconnaissance de charges représentatives de corps humain. De plus, des combinaisons de charges risquent de masquer la présence de contacts de corps humain et rendent ces dispositifs peu efficaces.

### EXPOSE DE L'INVENTION

L'invention a pour but un dispositif et un procédé de détection de charge ayant un taux de reconnaissance de charge représentative de corps humain élevé et un appareil comportant un tel dispositif pour contrôler efficacement la présence d'une telle charge.

Dans un dispositif de détection selon la revendication 1, les moyens d'injection injectent une tension électrique variable variant en valeurs absolues entre 20 et 150 volts et pouvant avoir au moins deux valeurs de tension pour provoquer une variation de l'impédance d'un corps humain, et comportent des moyens de limitation de courant, et les moyens de traitement déterminent la présence d'un corps humain en fonction de la variation d'impédance entre au moins deux valeurs de tensions différentes.
De préférence, les moyens d'injection injectent une tension électrique variable variant entre une première valeur et une seconde valeur, et comportent des moyens de limitation de courant.
De préférence, les moyens d'injection injectent ladite tension électrique variable entre au moins un conducteur de phase ou de neutre et un conducteur de masse ou de terre.
Selon une variante, les moyens d'injection injectent ladite tension électrique variable entre au moins deux conducteurs de phase ou de neutre.

Avantageusement, le dispositif comporte des moyens de signalisation de la détection d'un corps humain pour signaler la présence d'un corps humain ou la présence d'un autre défaut après ouverture de la ligne.
Avantageusement, le dispositif comporte des moyens de blocage de la fermeture de la ligne si la présence d'un corps humain est détectée.
Dans un mode de réalisation préférentiel, les moyens de traitement comportent des moyens d'échantillonnage pour fournir des valeurs d'impédance en fonction de valeur de tension, et des moyens de détermination de valeurs de variation d'impédance.
De préférence, les moyens de traitement comportent des moyens de détermination de valeurs d'échantillons de variation d'impédance, des moyens de calcul pour calculer une valeur moyenne d'échantillons de variation d'impédance, et des moyens de comparaison de la valeur moyenne des échantillons de variation d'impédance à un premier seuil.

Un appareil électrique selon la revendication 8 comporte une entrée destinée à être connectée à un réseau électrique, une sortie destinée à être connectée à une ligne électrique d'alimentation, des moyens d'interruption électrique connectés entre ladite entrée et ladite sortie, et un dispositif de détection de charge électrique tel que défini ci-dessus comportant des moyens de contrôle connectés à au moins un conducteur de la dite sortie pour injecter une tension variable, déterminer une variation d'impédance, et détecter une présence de corps humain en fonction de ladite variation d'impédance.
Dans un mode de réalisation préférentiel, les moyens de contrôle comportent une sortie de commande connectée à une commande de contrôle de l'ouverture et de la fermeture de contacts des moyens d'interruption pour empêcher la fermeture desdits contacts si une présence de corps humain est détectée.

De préférence, les moyens de contrôle injectent une tension électrique de mesure sur la ligne électrique après ouverture des moyens d'interruption pour détecter un type de défaut sur la ligne, et commander les moyens de signalisation pour signaler si un défaut dû à une présence de corps humain est détecté.

Un procédé de détection de charge électrique selon la revendication 11, comporte pendant la phase de contrôle :
- une étape d'injection d'une tension variable sur la ligne électrique, ladite injection étant limitée en courant,
- une étape de détermination de l'impédance d'une charge sur la ligne électrique, et de détermination de la variation de la dite impédance en fonction de la variation de ladite tension variable,
- une étape de détection d'une charge représentative de corps humain en fonction d'au moins une valeur de ladite variation d'impédance.

Avantageusement, dans le procédé de détection :
- l'étape de détermination de l'impédance d'une charge sur la ligne électrique comporte un échantillonnage de valeur de tension, de valeur d'impédance sur la ligne électrique, et de valeur de variation d'impédance, et
- l'étape de détection d'une charge représentative de corps humain comporte une étape de détermination d'au moins une valeur moyenne de la dite variation impédance et une étape de comparaison de ladite valeur moyenne à un seuil de détection pour détecter d'une charge représentative de corps humain.

De préférence, le procédé de détection comporte une étape de signalisation de la détection de la présence d'une charge représentative d'un corps humain.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente un schéma bloc d'un dispositif de l'état de la technique ;
- la figure 2 représente un schéma bloc d'un dispositif de détection selon un mode de réalisation de l'invention ;
- la figure 3 représente un exemple de graphique représentant la variation d'impédance du corps humain en fonction d'une tension ;
- la figure 4 représente le schéma d'un exemple de circuit d'injection de tension pour injecter une tension variable dans une ligne ;
- la figure 5 représente un exemple d'allure d'une tension variable injectée par un circuit selon la figure 4;
- la figure 6 représente un schéma bloc d'un circuit de traitement selon un mode de réalisation de l'invention ;
- la figure 7 représente un premier organigramme d'un exemple de procédé selon un mode de réalisation de l'invention ;
- les figures 8A, 8B, 8C, et 8D représentent des exemples de signaux représentatifs de tension, de courant, d'impédance, et de variation d'impédance dans une charge représentative d'un défaut différentiel ;
- les figures 9A, 9B, 9C, et 9D représentent des exemples de signaux représentatifs de tension, de courant, d'impédance, et de variation d'impédance dans une charge représentative d'un corps humain ;
- la figure 10 représente un graphique montrant un exemple de répartition d'échantillons de valeurs d'impédance et de variation d'impédance ;
- la figure 11 représente un second organigramme d'un exemple de procédé selon un mode de réalisation de l'invention ;
- la figure 12 représente un appareil comportant un dispositif de détection selon un mode de réalisation de l'invention ;
- la figure 13 représente des signaux de tension sur une ligne à contrôler par un dispositif de détection selon un mode de réalisation de l'invention.

### DESCRIPTION DETAILLEE DE MODES DE REALISATION PREFERES

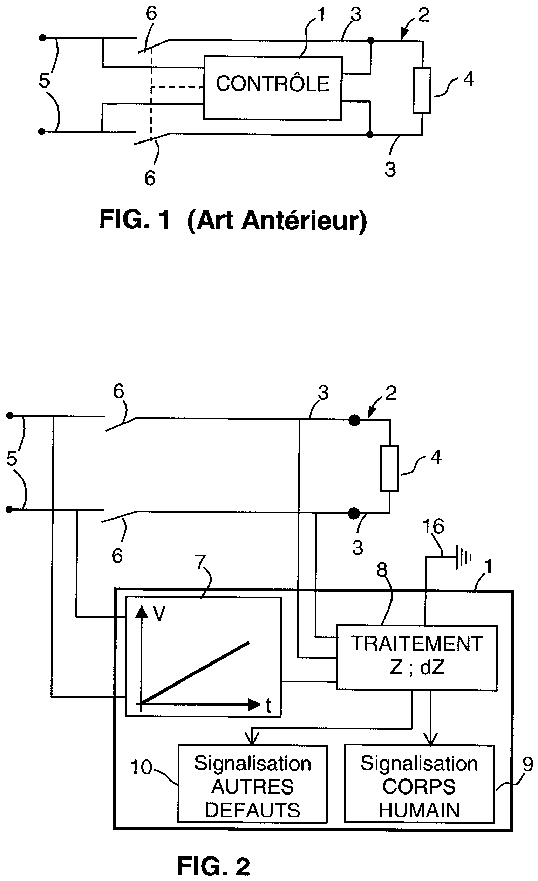

Un dispositif de détection de charge électrique connu représenté sur la figure 1 comporte un circuit de contrôle 1 connecté à une ligne 2 ayant des conducteurs 3 destinés à alimenter une charge électrique 4. Généralement le contrôle est fait par l'injection d'une tension électrique sur la ligne lorsque la ligne 2 n'est pas alimentée par un réseau électrique 5. Ainsi, des contacts 6 d'un interrupteur ou d'un disjoncteur permettent de déconnecter la ligne 2 du réseau 5. Le circuit de contrôle est alimenté par le réseau et comporte de manière connue une alimentation à isolement électrique entre le réseau 5 et la ligne 2.

Le circuit de contrôle 1 injecte une tension dans la ligne et détermine la valeur de l'impédance pour détecter la présence d'un corps humain ou d'un court-circuit. Par exemple, si l'impédance est supérieure à un seuil, il y a une possibilité de présence d'un corps humain.

Dans un dispositif de détection selon un mode de réalisation de l'invention, le circuit de contrôle comporte un circuit 7 d'injection d'une tension pour injecter une tension variable sur la ligne. La tension variable comporte au moins deux valeurs pour provoquer une variation d'impédance si un corps humain est en contact avec la ligne. Un circuit de traitement 8 contrôle l'injection de la tension variable et mesure l'impédance ou la résistance de la ligne pour des valeurs différentes de la tension variable. Si la variation d'impédance est représentative d'un corps humain le circuit de contrôle fournit un signal représentatif d'une détection de corps humain à un dispositif 9 de signalisation de corps humain. Si un autre défaut est détecté, le circuit de contrôle envoi un signal à un dispositif 10 de signalisation d'autres défauts, notamment des défauts différentiels ou de court-circuit. Les détections se font de préférence par des comparaisons des valeurs d'impédances ou de variations d'impédance avec des seuils de référence.

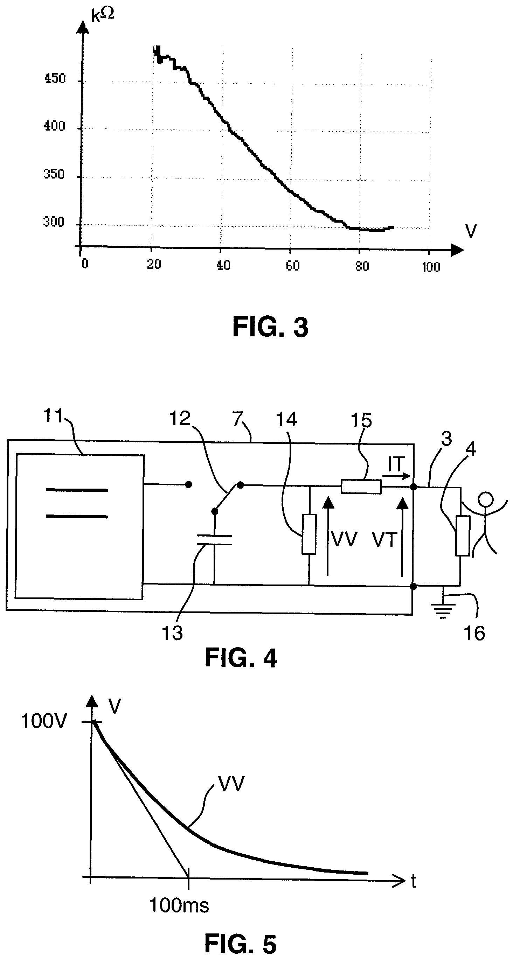

La figure 3 illustre un exemple de variation de l'impédance ou de la résistance d'un corps humain en fonction de la tension. La valeur de l'impédance et de l'ordre de 450 à 500 kilo-ohms (kΩ) pour 20V et diminue à environ 300 kilo-ohms (kΩ) pour 80V. Ainsi, pour détecter une présence de corps humain, un dispositif selon un mode de réalisation l'invention contrôle si l'impédance décroît dans des valeurs prédéfinies lorsque la tension électrique augmente.

Un mode de réalisation d'un circuit 7 d'injection d'une tension variable est représenté sur le schéma de la figure 4. Le circuit comporte une alimentation 11 de tension continue connectée à un commutateur 12 pour connecter un condensateur 13. Lorsque le condensateur est chargé, le commutateur est commandé pour connecter le condensateur 13 vers une résistance 14 de décharge. La tension sur la résistance a alors une forme d'une impulsion de tension décroissante VV. Cette tension variable est appliquée à au moins un conducteur 3 de la ligne 2 à contrôler. Pour limiter les effets de la tension électrique et donner une sécurité élevée au dispositif, une résistance 15 de limitation est connectée en série entre le commutateur et le conducteur 3 de ligne.

La tension est, de préférence, appliquée entre un conducteur de ligne et un conducteur 16 de terre ou de masse électrique. Une telle disposition permet de détecter la présence de corps humain par rapport à d'autre type de défauts à la terre par exemple un défaut différentiel ou un court-circuit à la terre. Avec un tel dispositif il est aussi possible de différencier la présence d'un corps humain par rapport à des charges sans défaut notamment des charges capacitives de filtres électriques qui ont un comportement particulier en présence d'impulsion électrique. Par exemple, une charge capacitive renvoie de la tension vers la source lorsque la tension de l'impulsion devient inférieure à la tension de charge des charges capacitives. L'impédance d'un corps humain est essentiellement résistive et peut donc être différenciée d'une charge capacitive.

La figure 5 montre un exemple d'une impulsion de tension décroissante VV fournie par un circuit d'injection 7 de la figure 4. L'impulsion a l'allure d'une exponentielle décroissante de constante de temps d'environ 100 mS et d'amplitude initiale d'environ 100 V.

Des valeurs préférentielles des éléments du circuit d'injection 5 peuvent être de 50 V à 150 V pour une tension maximale de la tension VV, de quelques microfarads (µF) pour le condensateur 13, et de quelques kilo ohms (kΩ) pour les résistances 14 et 15.

Pour déterminer l'impédance de la charge sur la ligne à contrôler ou entre la ligne et la terre, le dispositif de détection comporte des moyens de mesure de courant 17 pour mesurer un courant IT de test disposé par exemple sur une sortie d'un circuit d'injection 7 et de moyens de mesure d'une tension de test VT en sortie dudit circuit d'injection 7.

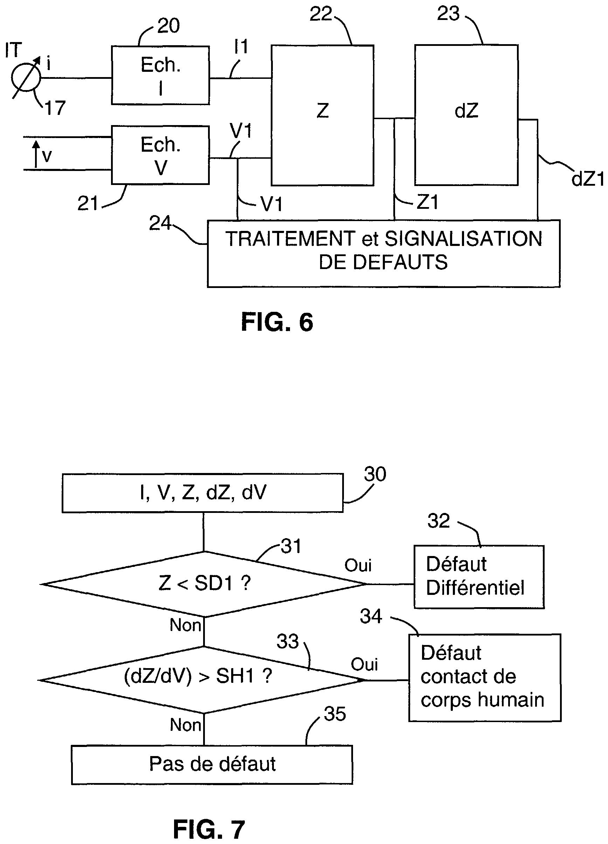

Un schéma d'un circuit de traitement 8 est représenté sur la figure 6. Il comporte un premier échantillonneur 20 recevant un signal i représentatif d'un courant de test IT, et un second échantillonneur 21 recevant un signal v représentatif d'une tension de test VT. Les échantillonneurs 20 et 21 fournissent respectivement des signaux d'échantillons I1 et V1 de courant de test et de tension de test. Les signaux I1 et V1 sont fournis à un détecteur d'impédance 22 pour déterminer l'impédance en fonction d'une charge sur la ligne. Le détecteur d'impédance fournit un signal Z1 d'impédance à un détecteur 23 de variation d'impédance pour déterminer la variation de l'impédance de la charge sur la ligne et fournir un signal dZ1 représentatif de la dite variation d'impédance. Les signaux V1, Z1 et dZ1 sont fournis à un circuit 24 de traitement et de signalisation de défaut pour déterminer si la ligne est en défaut et si un corps humain est en contact avec la ligne. Le signal de variation d'impédance dZ1 est utilisé avec le signal de tension V1 pour déterminer la présence de corps humain lorsque l'impédance varie en fonction de la tension. Il est aussi possible de noter la variation d'impédance en fonction de la variation de tension de la manière suivante |dZ|/|dV| pour vérifier la présence d'un corps humain. Par exemple, si (|dZ|/|dV|) est supérieur à un seuil SH de détection de corps humain, alors la détection est signalée et/ou l'alimentation de la ligne est bloquée.

Sur la figure 7, un organigramme montre un exemple le fonctionnement d'un dispositif ou d'un procédé de détection. A une étape 30, des valeurs de courant I et de tension V sont mesurées ou échantillonnées, pour déterminer des valeurs ou des échantillons d'une impédance Z, d'une variation d'impédance dZ, et d'une variation de tension dV. Les valeurs dZ et dV sont déterminées avec au moins deux points de mesure ou avec plusieurs échantillons.

A une étape 31 un test de la valeur de l'impédance est effectué, notamment pour déterminer un défaut différentiel si la tension de test est injectée entre un conducteur et la masse ou la terre. Si l'impédance Z est inférieure à un seuil SD, un défaut différentiel est signalé à une étape 32. A une étape 33 un test de la variation d'impédance par rapport à une variation de tension est effectué pour déterminer la présence d'un corps humain. Si la variation d'impédance par rapport à la variation de tension |dZ/dV| est supérieures à un seuil SH de détection, un défaut de présence de corps humain est signalé à une étape de 34. Si des défauts ne sont pas détectés, a une étape 35 l'alimentation de la ligne peut être autorisée.

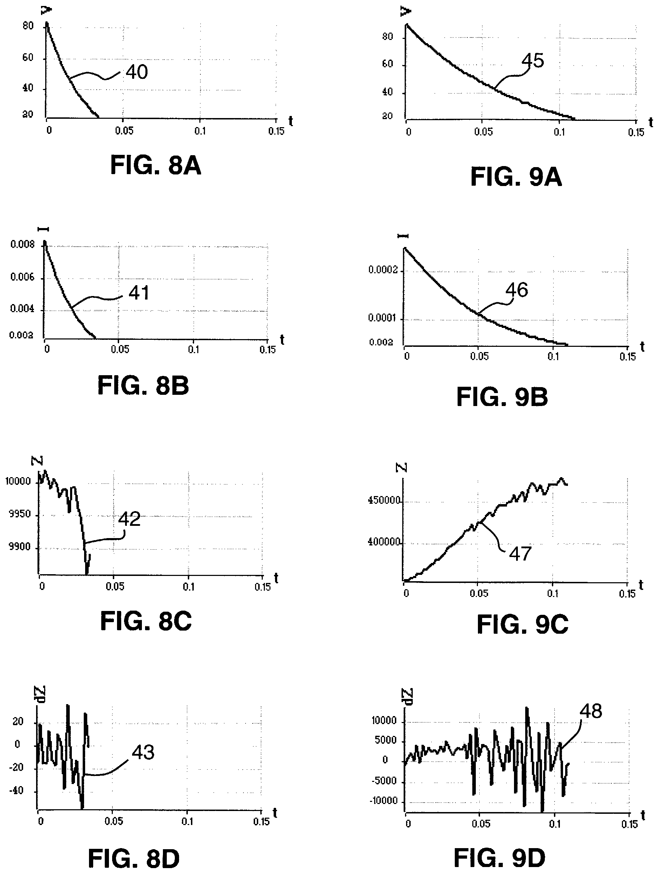

Les figures 8A à 8D montrent des allures de courbes de signaux sur un défaut différentiel. Une courbe 40 de la figure 8A représente un signal de tension V en fonction du temps lorsqu'une tension comme celle de la figure 5 est injectée. Une courbe 41 de la figure 8B représente un signal de courant I. Une courbe 42 de la figure 8C représente une impédance Z en fonction du temps déterminée en fonction de signaux V et I. Une courbe 43 de la figure 8D représente une variation d'impédance dZ. Cette variation d'impédance dZ peut être déterminée en fonction des valeurs d'impédance Z de la courbe 42, par exemple en effectuant la différence en deux échantillons de valeur d'impédance. Dans un système à échantillonnage, des échantillons de valeurs de V et de I permettent de déterminer une valeur d'échantillons d'impédance et deux valeurs d'échantillons d'impédance permettent de déterminer une valeur d'échantillon de variation d'impédance. Les valeurs d'échantillons d'impédance peuvent être des échantillons consécutifs ou des échantillons à intervalles plus grands. Sur la figure 8C, l'impédance est faible de l'ordre de 10kΩ, et la variation d'impédance représentée sur la figure 8D est très faible.

Les figures 9A à 9D montrent des allures de courbes de signaux sur une détection de charge représentative d'un corps humain. Une courbe 45 de la figure 9A représente un signal de tension V en fonction du temps lorsqu'une tension comme celle de la figure 5 est injectée. Une courbe 46 de la figure 9B représente un signal de courant I. Une courbe 47 de la figure 9C représente une impédance Z en fonction du temps déterminée en fonction de signaux V et I. Une courbe 48 de la figure 9D représente une variation d'impédance dZ. Cette variation d'impédance dZ peut être déterminée en fonction des valeurs d'impédance Z de la courbe 47, par exemple en effectuant la différence en deux échantillons de valeur d'impédance. Dans un système à échantillonnage, des échantillons de valeurs de V et de I permettent de déterminer une valeur d'échantillons d'impédance et deux valeurs d'échantillons d'impédance permettent de déterminer des valeurs d'échantillons de variation d'impédance. Les valeurs d'échantillons d'impédance peuvent être des échantillons consécutifs ou des échantillons à intervalles plus grands. Sur la figure 9C, l'impédance est élevée de l'ordre de 300 kΩ à 450 kΩ, et la variation d'impédance représentée sur la figure 9D est importante.

Avantageusement, les échantillons de valeurs de variation d'impédance peuvent être sommés pour avoir une valeur intégrée sur une variation de tension importante. Ainsi, pour retrouver une variation d'impédance avec une tension variant entre 100 volts et 20 volts, les valeurs d'échantillons peuvent être sommées sur une période correspondant à la variation de tension, par exemple environ 100 mS pour des signaux des figures 8D et 9D. De préférence, pour une bonne précision de la mesure, des échantillons correspondant à une tension qui devient basse ne sont pas pris en compte. Par exemple, lorsque la tension v est inférieur à 20 volts.

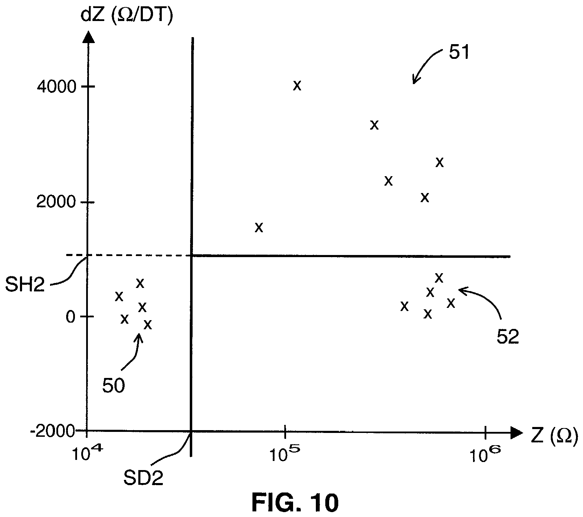

Sur la figure 10 un diagramme montre des répartitions de points correspondant à des couples d'échantillons d'impédance Z et de variation d'impédance dZ. Chaque couple peut aussi correspondre à des couples de moyennes d'échantillons d'impédance Z et de variations d'échantillons. Les valeurs de variations d'impédance ou de moyennes de variation d'impédance notées en Ω/DT et exprimé en fonction du temps sont indicatives, elles dépendent de la fréquence d'échantillonnage et de la forme et de la fréquence du signal représentatif de la tension injectée.

Le diagramme de la figure 10 comporte trois zones délimitées par un premier seuil SD2 d'impédance pour effectuer une détection de défaut différentiel, et un second seuil SH2 de variation d'impédance pour effectuer une détection de contact de corps humain. Les points correspondants à une impédance inférieure au seuil SD2 sont situés dans une première zone 50, ils correspondent à un défaut différentiel. Les points correspondant à une impédance supérieure au seuil SD2 et à une variation d'impédance supérieure au seuil SH2 sont situés sur une seconde zone 51, ils correspondent à une détection de corps humain. Les points correspondant à une impédance supérieure au seuil SD2 et à une variation d'impédance inférieure au seuil SH2 sont situés sur une seconde zone 52, ils correspondent à une charge sans défaut.

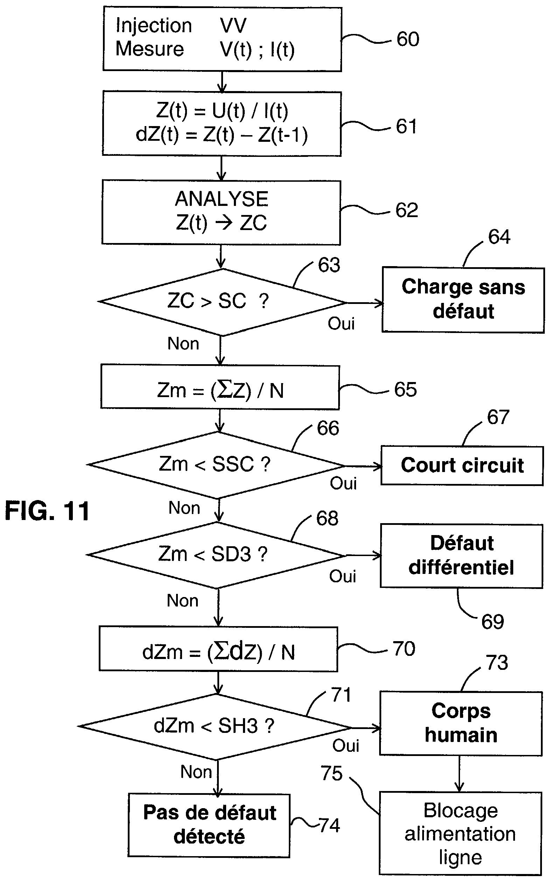

L'organigramme de la figure 11 représente un mode de fonctionnement et un procédé selon un autre mode de réalisation de l'invention. A une étape 60 un signal VV de test est injecté et une mesure de tension V(t) et de courant I(t) est effectuée par échantillonnage. A une étape 61 une impédance Z(t) échantillonnée est déterminée en fonction des échantillons de tension V(t) et de courant I(t), et une variation d'impédance dZ(t) est déterminée en faisant la différence entre un échantillon d'impédance Z(t) et un autre échantillon d'impédance précédent Z(t-1). A une étape 62, l'impédance Z(t) est analysée pour extraire une composante capacitive ZC. Cette composante ZC capacitive peut se manifester par une proportion importante de valeurs négatives d'impédance ou de variation d'impédance. La présence d'une valeur élevée de ZC peut indiquer notamment la présence de dispositifs de filtrage sur la ligne. A une étape 63, la valeur de ZC est comparée à un seuil SC. Si le seuil SC est dépassé, une étape 64 permet de signaler la présence de charge sans défaut ou une présence de charge capacitive.

A une étape 65, une valeur moyenne Zm de l'impédance Z est déterminée. Par exemple, la valeur Zm peut être calculée en faisant une somme d'échantillons d'impédance et en divisant cette somme par un nombre N d'échantillons utilisés. A une étape 66, la valeur moyenne de l'impédance Zm est comparée à un seuil SSC de court circuit. Si la valeur de Zm est inférieure au seuil SSC, une étape 67 permet de signaler la présence d'un court circuit. A une étape 68, La valeur moyenne de l'impédance Zm est comparée un seuil SD3 de défaut différentiel. Si la valeur de Zm est inférieure au seuil SD3, une étape 69 permet de signaler la présence d'un défaut différentiel.

A une étape 70, une valeur moyenne dZm de la variation d'impédance dZ est déterminée. Par exemple, la valeur dZm peut être calculée en faisant une somme d'échantillons de variation d'impédance et en divisant cette somme par un nombre N d'échantillons utilisés. A une étape 71, la valeur moyenne de la variation de l'impédance dZm est comparée à un seuil SH3 de détection de corps humain. Si la valeur de dZm est supérieure au seuil SH3, une étape 73 permet de signaler la détection d'un corps humain et/ou une étape 75 permet de bloquer l'alimentation de la ligne. Si des types de charges ne sont pas détectés, une étape 74 signale qu'il n'y a pas de défaut détecté.

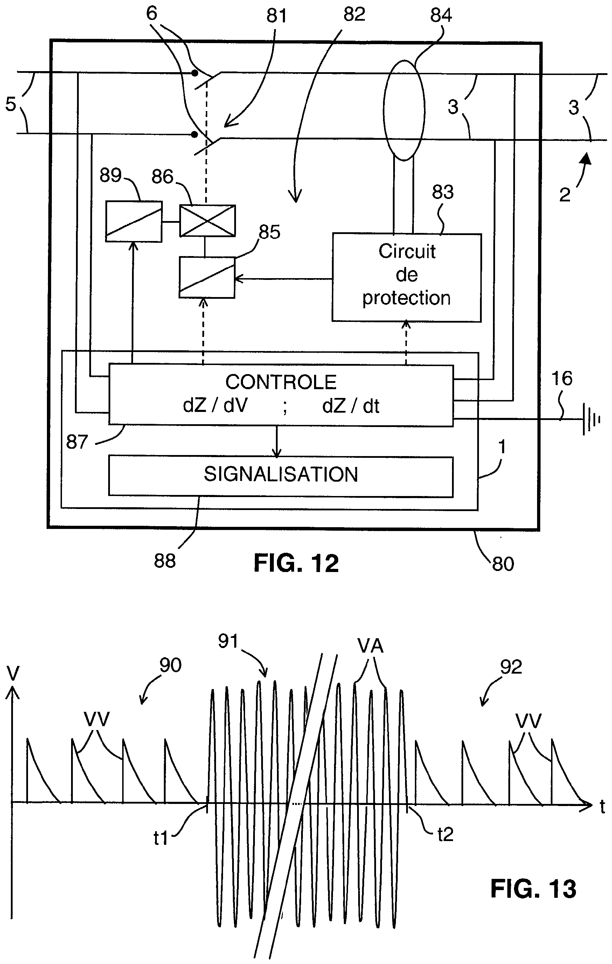

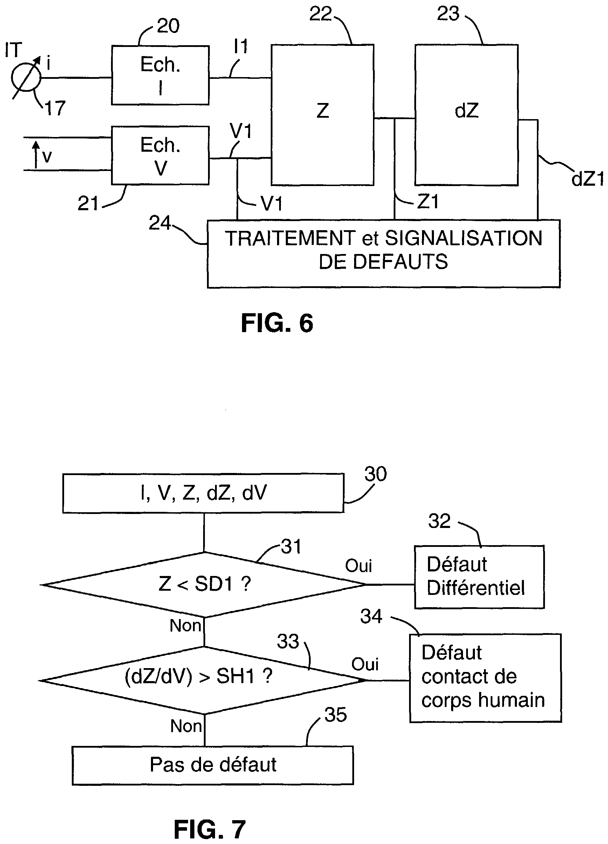

La figure 12 représente un appareil électrique 80 comportant un dispositif de détection de charges selon un mode de réalisation de l'invention. L'appareil comporte un dispositif de coupure 81 tel qu'un disjoncteur ou un interrupteur comportant de contacts 6 connectés entre le réseau 5 et la ligne 2. Le dispositif de coupure comporte un déclencheur 82 comportant un circuit 83 de protection connecté à un capteur 84 de courant différentiel et à un relais 85 de déclenchement d'un mécanisme 86 de l'ouverture de contacts 6. Généralement, le circuit de protection 83 commande le relais lorsqu'un signal de courant fournit par le tore dépasse un seuil prédéterminé.

L'appareil 1 comporte aussi un dispositif 1 de détection de charge comportant un circuit de contrôle 87 pour injecter une tension variable entre des conducteurs de la ligne 3 et la terre ou la masse, et pour détecter la présence d'un corps humain en fonction de la variation d'impédance provoquée par la variation de tension. Par exemple, le circuit de contrôle détecte la variation d'impédance en fonction de la variation de tension dZ/dV ou la variation d'impédance en fonction du temps dZ/dT si la tension injectée VV varie aussi en fonction du temps. Si une charge représentative d'un corps humain est détectée, le circuit de contrôle commande un circuit de signalisation 88 pour signaler la présence d'un corps humain et/ou pour verrouiller la fermeture des contacts 6. Le verrouillage des contacts peut être fait notamment par la commande d'un dispositif 89 de verrouillage, par la commande du relais 85 de déclenchement, ou par un signal appliqué au circuit de protection.

La figure 13 illustre des signaux de tension d'injection VV et des signaux d'alimentation VA de ligne correspondant à un exemple de fonctionnement d'un appareil selon la figure 12. Pendant une première période 90, une tension VV est injectée sur la ligne et le dispositif de détection contrôle la charge pour détecter une présence de corps humain. A un instant t1, les contacts 6 sont fermés et la ligne est alimentée par une tension VA du réseau 5 pendant une période 91. A un instant t2, les contacts 6 sont ouverts et le dispositif de détection contrôle de nouveau la ligne pendant une période 92. Si l'ouverture a été provoquée par un défaut électrique qui subsiste, le dispositif signale alors le type de défaut et la présence d'un corps humain si une telle charge est détectée.

Les schémas des figures montrent des dispositifs utilisés sur des lignes monophasées à deux conducteurs mais d'autres lignes, notamment des lignes triphasées, peuvent être contrôlées par des dispositifs selon des modes de réalisation de l'invention.

Les tensions variables VV injectées pour détecter la présence d'un corps humain ont des valeurs de préférence entre 0 et 240 volts, avantageusement entre 20 volts et 150 volts, avec plusieurs formes possibles notamment des d'impulsions exponentielles, des dents de scie, des rampes triangulaires, ou des valeurs discrètes en palier. La fréquence d'injection des impulsions peut être adaptée à l'utilisation et au niveau d'énergie.

Les circuits de contrôle de traitement et de signalisation peuvent être réalisés en plusieurs circuits ou groupés en un seul circuit. Ils peuvent comporter des circuits analogiques, logiques et/ou programmables pour réaliser les différentes fonctions du dispositif ou mettre en oeuvre de procédé.

La détection de corps humain décrite ci-dessus peut aussi être comprise comme la détection d'un être vivant mammifère ayant des caractéristiques électriques proches ou du même type.

## Revendications

1. Dispositif de détection de charge électrique comportant des moyens (1) de contrôle destinés à être connectés à au moins un conducteur (3) d'une ligne (2) électrique et des moyens (9, 10, 88) de signalisation connectés audits moyens de contrôle, les moyens de contrôle comportant :
- des moyens (7) d'injection pour injecter une tension électrique de mesure sur la ligne (2) électrique lorsque ladite ligne est déconnectée d'un réseau (5) fournissant une énergie électrique,
- des moyens (22) de détection d'impédance pour détecter l'impédance d'une charge électrique, et
- des moyens (8) de traitement pour déterminer si ladite charge est représentative de la présence d'un corps humain, dispositif **caractérisé en ce que** les moyens (7) d'injection injectent une tension électrique variable (VV) variant entre une première valeur et une seconde valeur et pouvant avoir au moins deux valeurs de tension pour provoquer une variation de l'impédance (dZ) d'un corps humain, et comportent des moyens (15) de limitation de courant, et les moyens de traitement (8, 23, 24, 30, 33, 61, 71, 87) déterminent la présence d'un corps humain en fonction de la variation d'impédance (dZ) entre au moins deux valeurs de tensions (W) différentes, lesdites première et seconde valeurs de tension variable (W) étant comprises entre 20 et 150 volts en valeurs absolues.

2. Dispositif selon la revendication 1 **caractérisé en ce que** les moyens d'injection (7) injectent ladite tension électrique variable entre au moins un conducteur (3) de phase ou de neutre et un conducteur (16) de masse ou de terre.

3. Dispositif selon l'une des revendications 1 ou 2 **caractérisé en ce que** les moyens d'injection injectent ladite tension électrique variable entre au moins deux conducteurs (3) de phase ou de neutre.

4. Dispositif selon l'une quelconque des revendications 1 à 3 **caractérisé en ce qu'**il comporte des moyens (9, 10, 24, 32, 34, 67, 69, 73, 88) de signalisation de la détection d'un corps humain pour signaler la présence d'un corps humain ou la présence d'un autre défaut après ouverture de la ligne (2).

5. Dispositif selon l'une quelconque des revendications 1 à 4 **caractérisé en ce qu'**il comporte des moyens de blocage (75, 34, 83, 85, 86, 89) de la fermeture de la ligne si la présence d'un corps humain est détectée.

6. Dispositif selon l'une quelconque des revendications 1 à 5 **caractérisé en ce que** les moyens de traitement comportent des moyens d'échantillonnage (20, 21, 22, 61) pour fournir des valeurs d'impédance (Z1, Z(t)) en fonction de valeur de tension (V1, V(t)), et des moyens (23, 61) de détermination de valeurs de variation d'impédance (dZ1, dZ(t)).

7. Dispositif selon la revendication 6 **caractérisé en ce que** les moyens de traitement comportent des moyens (23, 61) de détermination de valeurs d'échantillons (dZ1, dZ(t)) de variation d'impédance, des moyens (70) de calcul pour calculer une valeur moyenne (dZm) d'échantillons de variation d'impédance, et des moyens (71) de comparaison de la valeur moyenne des échantillons de variation d'impédance à un premier seuil (SH3).

8. Appareil électrique comportant une entrée destinée à être connectée à un réseau (5) électrique, une sortie destinée à être connectée à une ligne (2, 3) électrique d'alimentation, et des moyens (6, 81) d'interruption électrique connectés entre ladite entrée et ladite sortie, appareil **caractérisé en ce qu'**il comporte un dispositif de détection (1) de charge électrique selon l'une des revendications 1 à 7 comportant des moyens de contrôle (87) connectés à au moins un conducteur (3) de la dite sortie pour injecter une tension (W) variable, déterminer une variation d'impédance, et détecter une présence de corps humain en fonction de ladite variation d'impédance.

9. Appareil selon la revendication 8 **caractérisé en ce que** les moyens de contrôle comportent une sortie de commande connectée à une commande (83, 85, 86, 89) de contrôle de l'ouverture et de la fermeture de contacts (6) des moyens d'interruption (81) pour empêcher la fermeture desdits contacts si une présence de corps humain est détectée.

10. Appareil selon l'une des revendications 8 ou 9 **caractérisé en ce que** les moyens de contrôle injectent une tension électrique de mesure (W) sur la ligne (2) électrique après ouverture des moyens (6, 81) d'interruption pour détecter un type de défaut sur la ligne, et commander les moyens (88) de signalisation pour signaler si un défaut dû à une présence de corps humain est détecté.

11. Procédé de détection de charge électrique dans au moins un conducteur (3) d'une ligne (2) électrique comportant une phase (90, 92) de contrôle lorsque la ligne n'est pas alimentée par un réseau électrique
**caractérisé en ce qu'**il comporte pendant la phase de contrôle :
- une étape (60) d'injection d'une tension variable (W) sur la ligne électrique, ladite injection étant limitée en courant, des valeurs de tension variable (W) en valeurs absolues étant comprises entre 20 et 150 volts.
- une étape (30, 61) de détermination de l'impédance (Z, Z1, Z(t)) d'une charge sur la ligne électrique, et de détermination de la variation (dZ, dZ1, dZ(t)) de la dite impédance en fonction de la variation de ladite tension variable,
- une étape (33, 70, 71) de détection d'une charge représentative de corps humain en fonction d'au moins une valeur de ladite variation d'impédance.

12. Procédé de détection de charge électrique selon la revendication 11 **caractérisé en ce que** :
- l'étape (30, 61) de détermination de l'impédance d'une charge sur la ligne électrique comporte un échantillonnage de valeur de tension (21, V(t)), de valeur d'impédance (22, Z1, Z(t)) sur la ligne électrique, et de valeur de variation d'impédance (23, dZ1, dZ(t)), et
- l'étape (33, 70, 71) de détection d'une charge représentative de corps humain comporte une étape (70) de détermination d'au moins une valeur moyenne (dZm) de la dite variation impédance et une étape (71) de comparaison de ladite valeur moyenne à un seuil (SH3) de détection pour détecter d'une charge représentative de corps humain.

13. Procédé de détection de charge électrique selon l'une des revendications 11 ou 12 **caractérisé en ce qu'**il comporte une étape (34, 73) de signalisation de la détection de la présence d'une charge représentative d'un corps humain.

## Patentansprüche

1. Vorrichtung zur Detektion von elektrischen Ladungen, umfassend Steuermittel (1), die dazu bestimmt sind, an mindestens einen Leiter (3) einer elektrischen Leitung (2) angeschlossen zu werden, und Signalisierungsmittel (9, 10, 88), die an die Steuermittel angeschlossen sind, wobei die Steuermittel aufweisen:
- Mittel (7) zum Injizieren, um eine elektrische Messspannung in die elektrische Leitung (2) zu injizieren, wenn die Leitung von einem Netz (5) abgetrennt ist, das eine elektrische Energie liefert,
- Mittel (22) zur Detektion einer Impedanz, um die Impedanz einer elektrischen Ladung zu detektieren, und
- Verarbeitungsmittel (8), um zu bestimmen, ob die Ladung für die Anwesenheit eines menschlichen Körpers repräsentativ ist,
Vorrichtung, **dadurch gekennzeichnet, dass** die Mittel (7) zum Injizieren eine variable elektrische Spannung (VV) injizieren, die zwischen einem ersten Wert und einem zweiten Wert variiert und mindestens zwei Spannungswerte aufweisen kann, um eine Änderung der Impedanz (dZ) eines menschlichen Körpers zu bewirken, und Strombegrenzungsmittel (15) aufweisen, und die Verarbeitungsmittel (8, 23, 24, 30, 33, 61, 71, 87) die Anwesenheit eines menschlichen Körpers in Abhängigkeit von der Änderung der Impedanz (dZ) zwischen mindestens zwei verschiedenen Spannungswerten (VV) bestimmen, wobei der erste und der zweite variable Spannungswert (VV) in Absolutwerten zwischen 20 und 150 Volt betragen.

2. Vorrichtung nach Anspruch 1, **dadurch gekennzeichnet, dass** die Mittel (7) zum Injizieren die variable elektrische Spannung zwischen mindestens einem Phasen- oder Nullleiter (3) und einem Masse- oder Erdungsleiter (16) injizieren.

3. Vorrichtung nach einem der Ansprüche 1 oder 2, **dadurch gekennzeichnet, dass** die Mittel zum Injizieren die variable elektrische Spannung zwischen mindestens zwei Phasen- oder Nullleitern (3) injizieren.

4. Vorrichtung nach einem der Ansprüche 1 bis 3, **dadurch gekennzeichnet, dass** sie Mittel (9, 10, 24, 32, 34, 67, 69, 73, 88) zum Signalisieren der Detektion eines menschlichen Körpers aufweist, um die Anwesenheit eines menschlichen Körpers oder die Anwesenheit eines anderen Defekts nach dem Öffnen der Leitung (2) zu signalisieren.

5. Vorrichtung nach einem der Ansprüche 1 bis 4, **dadurch gekennzeichnet, dass** sie Mittel zum Blockieren (75, 34, 83, 85, 86, 89) des Schließens der Leitung aufweist, wenn die Anwesenheit eines menschlichen Körpers detektiert wird.

6. Vorrichtung nach einem der Ansprüche 1 bis 5, **dadurch gekennzeichnet, dass** die Verarbeitungsmittel Abtastmittel (20, 21, 22, 61), um Impedanzwerte (Z1, Z(t)) in Abhängigkeit von dem Spannungswert (V1, V(t)) zu liefern, und Mittel (23, 61) zum Bestimmen von Impedanzänderungswerten (dZ1, dZ(t)) aufweisen.

7. Vorrichtung nach Anspruch 6, **dadurch gekennzeichnet, dass** die Verarbeitungsmittel Mittel (23, 61) zum Bestimmen von Abtastwerten (dZ1, dZ(t)) von Impedanzänderungen, Berechnungsmittel (70), um einen Durchschnittsabtastwert (dZm) von Impedanzänderungen zu berechnen, und Mittel (71) zum Vergleichen des Durchschnittsabtastwerts von Impedanzänderungen mit einem ersten Schwellenwert (SH3) aufweisen.

8. Elektrisches Gerät, umfassend einen Eingang, der dazu bestimmt ist, an ein Stromnetz (5) angeschlossen zu werden, einen Ausgang, der dazu bestimmt ist, an eine Stromversorgungsleitung (2, 3) angeschlossen zu werden, und Stromunterbrechungsmittel (6, 81), die zwischen dem Eingang und dem Ausgang angeschlossen sind, Gerät, **dadurch gekennzeichnet, dass** es eine Vorrichtung zur Detektion (1) von elektrischen Ladungen nach einem der Ansprüche 1 bis 7 aufweist, umfassend Steuermittel (87), die an mindestens einen Leiter (3) des Ausgangs angeschlossen sind, um eine variable Spannung (VV) zu injizieren, eine Impedanzänderung zu bestimmen und eine Anwesenheit eines menschlichen Körpers in Abhängigkeit von der Impedanzänderung zu detektieren.

9. Gerät nach Anspruch 8, **dadurch gekennzeichnet, dass** die Steuermittel einen Steuerausgang aufweisen, der an eine Steuerung (83, 85, 86, 89) zum Steuern des Öffnens und des Schließens der Kontakte (6) der Unterbrechungsmittel (81) angeschlossen ist, um das Schließen der Kontakte zu verhindern, wenn ein Vorhandensein eines menschlichen Körpers detektiert wird.

10. Gerät nach einem der Ansprüche 8 oder 9 **dadurch gekennzeichnet, dass** die Steuermittel nach dem Öffnen der Unterbrechungsmittel (6, 81) eine elektrische Messspannung (VV) in die elektrische Leitung (2) injizieren, um eine Art von Defekt in der Leitung zu detektieren und die Signalisierungsmittel (88) zu steuern, um zu signalisieren, ob ein Defekt aufgrund eines Vorhandenseins eines menschlichen Körpers detektiert wird.

11. Verfahren zur Detektion von elektrischen Ladungen in mindestens einem Leiter (3) einer elektrischen Leitung (2), umfassend eine Steuerphase (90, 92), wenn die Leitung nicht von einem Stromnetz gespeist wird, **dadurch gekennzeichnet, dass** es während der Steuerphase aufweist:
- einen Schritt (60) des Injizierens einer variablen Spannung (VV) in die elektrische Leitung, wobei das Injizieren strombegrenzt ist, wobei Werte variabler Spannung (VV) in absoluten Werten zwischen 20 und 150 Volt betragen,
- einen Schritt (30, 61) des Bestimmens der Impedanz (Z, Z1, Z(t)) einer Ladung auf der elektrischen Leitung und des Bestimmens der Änderung (dZ, dZ1, dZ(t)) der Impedanz in Abhängigkeit von der Änderung der variablen Spannung,
- einen Schritt (33, 70, 71) der Detektion einer Ladung, die für einen menschlichen Körper repräsentativ ist, in Abhängigkeit von mindestens einem Wert der Impedanzänderung.

12. Verfahren zur Detektion von elektrischen Ladungen nach Anspruch 11, **dadurch gekennzeichnet, dass**:
- der Schritt (30, 61) des Bestimmens der Impedanz einer Ladung auf der elektrischen Leitung ein Abtasten des Spannungswertes (21, V(t)), des Impedanzwertes (22, Z1, Z(t)) auf der elektrischen Leitung und des Wertes der Impedanzänderung (23, dZ1, dZ(t)) aufweist, und
- der Schritt (33, 70, 71) der Detektion einer Ladung, die für einen menschlichen Körper repräsentativ ist, einen Schritt (70) des Bestimmens von mindestens einem Durchschnittswert (dZm) der Impedanzänderung und einen Schritt (71) des Vergleichens des Durchschnittswerts mit einem Schwellenwert (SH3) der Detektion aufweist, um eine Ladung zu detektieren, die für einen menschlichen Körper repräsentativ ist.

13. Verfahren zur Detektion von elektrischen Ladungen nach einem der Ansprüche 11 oder 12, **dadurch gekennzeichnet, dass** es einen Schritt (34, 73) des Signalisierens der Detektion eines Vorhandenseins einer Ladung, die für einen menschlichen Körper repräsentativ ist, aufweist.

## Claims

1. Electrical load detection device including monitoring means (1) intended to be connected to at least one conductor (3) of an electrical line (2) and signalling means (9, 10, 88) connected to said monitoring means, the monitoring means including:
- injection means (7) for injecting an electric measurement voltage onto the electrical line (2) when said line is disconnected from a network (5) supplying electric power,
- impedance detection means (22) for detecting the impedance of an electrical load, and
- processing means (8) for determining whether said load is representative of the presence of a human body,
which device is **characterized in that** the injection means (7) inject a variable electric voltage (VV) that varies between a first value and a second value and is able to have at least two voltage values so as to bring about a variation in the impedance (dZ) of a human body, and include current limitation means (15), and the processing means (8, 23, 24, 30, 33, 61, 71, 87) determine the presence of a human body on the basis of the impedance variation (dZ) between at least two different voltage values (VV), said first and second variable voltage values (VV) being between 20 and 150 volts in terms of absolute values.

2. Device according to Claim 1, **characterized in that** the injection means (7) inject said variable electric voltage between at least one phase or neutral conductor (3) and a ground or earth conductor (16).

3. Device according to either of Claims 1 and 2, **characterized in that** the injection means inject said variable electric voltage between at least two phase or neutral conductors (3).

4. Device according to any one of Claims 1 to 3, **characterized in that** it includes means (9, 10, 24, 32, 34, 67, 69, 73, 88) for signalling the detection of a human body for signalling the presence of a human body or the presence of another fault after opening of the line (2).

5. Device according to any one of Claims 1 to 4, **characterized in that** it includes means (75, 34, 83, 85, 86, 89) for blocking the closure of the line if the presence of a human body is detected.

6. Device according to any one of Claims 1 to 5, **characterized in that** the processing means include sampling means (20, 21, 22, 61) for supplying impedance values (Z1, Z(t)) on the basis of a voltage value (V1, V(t)), and means (23, 61) for determining impedance variation values (dZ1, dZ(t)).

7. Device according to Claim 6, **characterized in that** the processing means include means (23, 61) for determining sample values (dZ1, dZ(t)) of impedance variation, calculating means (70) for calculating an average value (dZm) of impedance variation samples, and means (71) for comparing the average value of the impedance variation samples with a first threshold (SH3).

8. Electrical unit including an input intended to be connected to an electrical network (5), an output intended to be connected to an electric power supply line (2, 3), and electrical switching means (6, 81) connected between said input and said output, which unit is **characterized in that** it includes an electrical load detection device (1) according to one of Claims 1 to 7, including monitoring means (87) connected to at least one conductor (3) of said output in order to inject a variable voltage (VV), determine an impedance variation, and detect the presence of a human body on the basis of said impedance variation.

9. Unit according to Claim 8, **characterized in that** the monitoring means include a control output connected to a controller (83, 85, 86, 89) for monitoring the opening and the closure of contacts (6) of the switching means (81) in order to prevent the closure of said contacts if the presence of a human body is detected.

10. Unit according to either of Claims 8 and 9, **characterized in that** the monitoring means inject an electric measurement voltage (VV) onto the electrical line (2) after opening of the switching means (6, 81) in order to detect a type of fault on the line, and control the signalling means (88) so as to signal if a fault due to the presence of a human body is detected.

11. Method for detecting an electrical load in at least one conductor (3) of an electrical line (2), including a monitoring phase (90, 92) when the line is not supplied with power by an electrical network,
**characterized in that** it includes, during the monitoring phase:
- a step (60) of injecting a variable voltage (VV) onto the electrical line, said injection being limited in terms of current, variable voltage values (VV), in terms of absolute values, being between 20 and 150 volts,
- a step (30, 61) of determining the impedance (Z, Z1, Z(t)) of a load on the electrical line, and of determining the variation (dZ, dZ1, dZ(t)) in said impedance on the basis of the variation in said variable voltage,
- a step (33, 70, 71) of detecting a load representative of a human body on the basis of at least one value of said impedance variation.

12. Electrical load detection method according to Claim 11, **characterized in that**:
- the step (30, 61) of determining the impedance of a load on the electrical line includes sampling a voltage value (21, V(t)), an impedance value (22, Z1, Z(t)) on the electrical line, and an impedance variation value (23, dZ1, dZ(t)), and
- the step (33, 70, 71) of detecting a load representative of a human body includes a step (70) of determining at least one average value (dZm) of said impedance variation and a step (71) of comparing said average value with a detection threshold (SH3) in order to detect a load representative of a human body.

13. Electrical load detection method according to either of Claims 11 and 12, **characterized in that** it includes a step (34, 73) of signalling the detection of the presence of a load representative of a human body.
